(19) Europäisches Patentamt
European Patent Office
Office européen des brevets

(11) **EP 1 962 338 A1**

(12) **EUROPEAN PATENT APPLICATION**
published in accordance with Art. 158(3) EPC

(43) Date of publication:
**27.08.2008 Bulletin 2008/35**

(51) Int Cl.:
*H01L 21/338* (2006.01)    *H01L 29/06* (2006.01)
*H01L 29/778* (2006.01)    *H01L 29/812* (2006.01)

(21) Application number: **06834508.1**

(22) Date of filing: **12.12.2006**

(86) International application number:
**PCT/JP2006/324753**

(87) International publication number:
**WO 2007/069601 (21.06.2007 Gazette 2007/25)**

(84) Designated Contracting States:
**DE**

(30) Priority: **14.12.2005 JP 2005359820**

(71) Applicant: **NEC Corporation**
**Minato-ku**
**Tokyo 108-8001 (JP)**

(72) Inventors:
• **MATSUNAGA, Kouji**
**Tokyo 108-8001 (JP)**
• **OTA, Kazuki**
**Tokyo 108-8001 (JP)**
• **OKAMOTO, Yasuhiro**
**Tokyo 108-8001 (JP)**

• **NAKAYAMA, Tatsuo**
**Tokyo 108-8001 (JP)**
• **WAKEJIMA, Akio**
**Tokyo 108-8001 (JP)**
• **ANDO, Yuji**
**Tokyo 108-8001 (JP)**
• **MIYAMOTO, Hironobu**
**Tokyo 108-8001 (JP)**
• **INOUE, Takashi**
**Tokyo 108-8001 (JP)**
• **MURASE, Yasuhiro**
**Tokyo 108-8001 (JP)**

(74) Representative: **Glawe, Delfs, Moll**
**Patentanwälte**
**Postfach 26 01 62**
**80058 München (DE)**

(54) **FIELD EFFECT TRANSISTOR**

(57)    A semiconductor device 100 contains an undoped GaN channel layer 105, an AlGaN electron donor layer 106 provided on the undoped GaN channel layer 105 as being brought into contact therewith, an undoped GaN layer 107 provided on the AlGaN electron donor layer 106, a source electrode 101 and a drain electrode 103 provided on the undoped GaN layer 107 as being spaced from each other, a recess 111 provided in the region between the source electrode 101 and the drain electrode 103, as being extended through the undoped GaN layer 107, a gate electrode 102 buried in the recess 111 as being brought into contact with the AlGaN electron donor layer 106 on the bottom surface thereof, and an SiN film 108 provided on the undoped GaN layer 107, in the region between the gate electrode 102 and the drain electrode 103.

FIG. 1

100

EP 1 962 338 A1

**Description**

TECHNICAL FIELD

The present invention relates to a field effect transistor using Group III nitride semiconductors.

BACKGROUND ART

In recent years, electronic devices having an AlGaN (upper layer) /GaN (lower layer (substrate side)) structure have more extensively been developed. The AlGaN/GaN structure has high voltage breakdown characteristics by virtue of its wide band gap characteristics, and are discussed to be applied in particular for high-frequency/high-output devices operated under higher voltages, and inverter power sources.

There is known a conventional hetero-junction transistor having the AlGaN/GaN structure, described in Patent Document 1. FIG. 2 is a schematic sectional view showing a basic configuration of transistor described in the document.

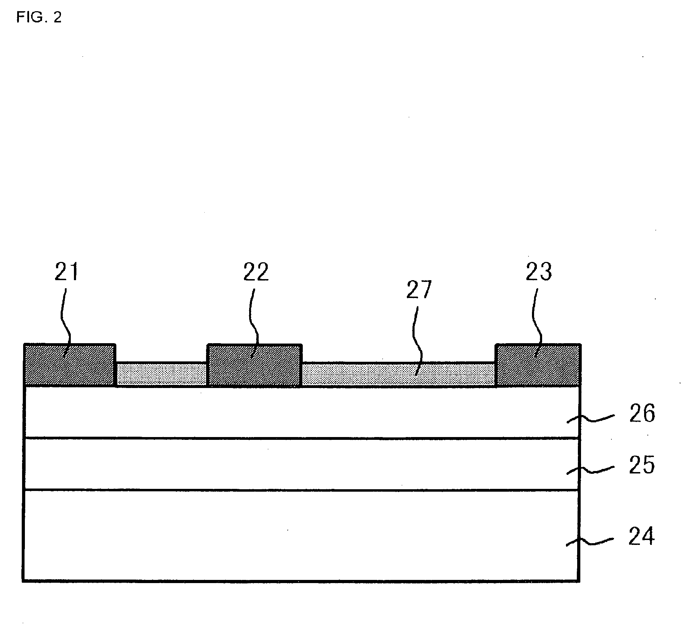

The transistor shown in FIG. 2 is manufactured by the procedures below.

First, over a high-resistivity SiC substrate 24, an undoped GaN (i-GaN) channel layer 25 which serves as a channel layer and an AlGaN electron donor layer 26 composed of n-type AlGaN are sequentially deposited by the MOCVD process. A SiN film 27 is then deposited by the CVD process. Thereafter, openings are formed by removing the SiN film 27 specifically in regions where a gate electrode 22, a drain electrode 23 and a source electrode 21 will be formed later, and the electrodes are then formed. In this way, a basic structure shown in FIG. 2 is obtained. In the structure, the gate electrode 22 is formed over the AlGaN electron donor layer 26 as being brought into contact therewith.

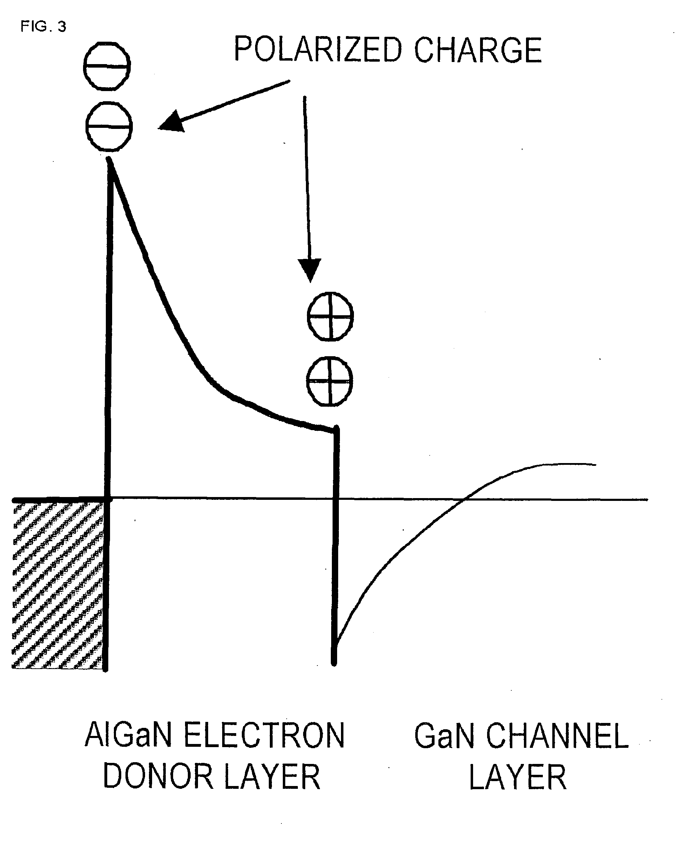

FIG. 3 is a drawing showing a band chart of a region right under the gate electrode 22 of the transistor shown in FIG. 2.

As shown in FIG. 3, right under the gate electrode 22, a large Piezoelectric polarization appears between the AlGaN electron donor layer 26 and the undoped GaN channel layer 25, ascribable to lattice mismatching therebetween. As a consequence, at the interface between the AlGaN electron donor layer 26 and the undoped GaN channel layer 25, positive polarized charge generates in the AlGaN electron donor layer 26, and negative two-dimensional electron gas is induced in the undoped GaN channel layer 25. On the surface side of the AlGaN electron donor layer 26, that is, at the interface on the gate electrode side thereof, negative charge as much as being balanced with the positive charge, generated by Piezoelectric and spontaneous polarization, is induced in the AlGaN electron donor layer 26.

Increase in Al content of the AlGaN electron donor layer 26 results in generation of larger amounts of charge by polarization, and increase in the sheet carrier concentration, and thereby the transistor may be given as of larger current type. For example, the sheet carrier concentration of the two-dimensional electron gas is approximately ten times as large as that of GaAs-base semiconductors. In addition, by virtue of its wide band gap feature, a power density exceeding by far that of the GaAs-base semiconductors is reported.

The surficial SiN film 27 herein is introduced in order to reduce external influences and stabilize the operation. The SiN film 27 closely affects deep levels at around the surficial portion of the AlGaN electron donor layer 26 and polarized charge.

If the thickness of the SiN film 27 is large, polarized charge and donor levels may be compensated. Therefore, the interface between the AlGaN electron donor layer 26 and the SiN film 27 behaves as an ideal interface having no levels (any influence excluded). On the contrary, when the SiN film 27 is not provided, or when the SiN film 27 has only a small thickness, the polarized charge and donor levels are compensated only to an insufficient degree, leaving the surficial levels uncompensated. Therefore, transistor characteristics may largely vary depending on the thickness of the SiN film 27.

A specific problem possibly arisen when the SiN film 27 is not provided, or the SiN film 27 has only a small thickness, is known as current collapse. The collapse means that, when the transistor operates under large signals, the transistor shifts from the state where negative charge is released and trapped to the state where trapping is maintained, due to response of the surface levels, and thereby the maximum drain current is suppressed. If the collapse becomes distinctive, drain current under large signal operation may be suppressed, and thereby the saturation output may be lowered. The collapse may occasionally produce hysteresis in the I-V characteristics, and may possibly destabilize the operations.

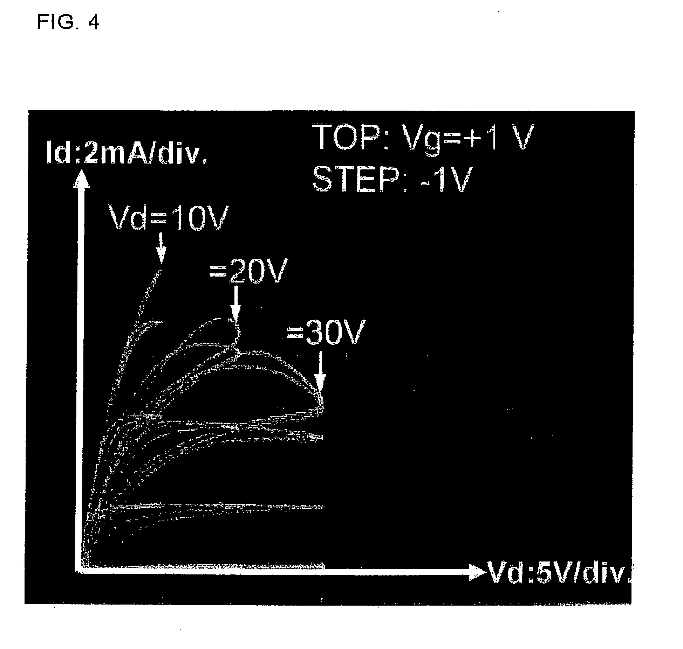

FIG. 4 is a drawing showing the IV characteristics actually measured for a configuration having no SiN film 27 provided thereto. As shown in FIG. 4, large hystereses can be seen in the IV characteristics for the case where the SiN film is not provided.

As has been described in the above, it may be necessary to thicken the SiN film 27 to a certain extent or more, in order to fully reduce the collapse. However, thickened SiN film 27 may cancel the surface negative charge, current may more strongly be concentrated in the region between the gate and the drain, and thereby breakdown voltage of gate may be lowered. In short, tradeoff resides between the collapse and the breakdown voltage of gate.

2

The breakdown voltage of gate in the context of this specification means voltage at which gate leakage current begins to flow in the gate-drain reverse direction, when reverse voltage was applied between the gate and the drain.

By the way, there is known a technique of improving the IV characteristics of transistor described in Patent Document 2. Patent Document 2 describes a HEMT (high electron mobility transistor) using an n-type $Al_{0.25}Ga_{0.75}N$ layer as a carrier donor layer, and an i-GaN layer as a carrier moving layer. The document shows a structure having, as being incorporated as the surface layer into the upper portion of the carrier donor layer, a GaN layer having the same conductivity type with the carrier moving layer, that is an n-type GaN layer.

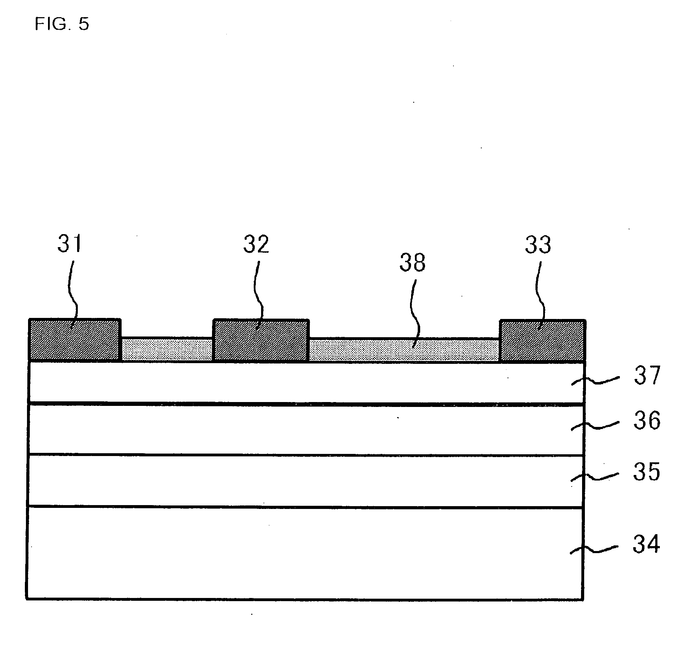

FIG. 5 is a sectional view showing a basic configuration of the transistor described in the document.

In the transistor shown in FIG. 5, a GaN channel layer 35, an AlGaN electron donor layer 36 and an n-type GaN layer 37 are stacked in this order on a substrate 34. On the GaN layer 37, a source electrode 31, a drain electrode 33 and a gate electrode 32 are provided. A SiN film 38 is provided in the region between the source electrode 31 and the gate electrode 32, and the region between the gate electrode 32 and the drain electrode 33.

[Patent Document 1] Japanese Laid-Open Patent Publication No. 2004-342810
[Patent Document 2] Japanese Laid-Open Patent Publication No. 2002-359256

DISCLOSURE OF THE INVENTION

The present inventors extensively investigated into the transistor having the basic configuration described in the above referring to FIG. 5. Details of the investigation will be explained below.

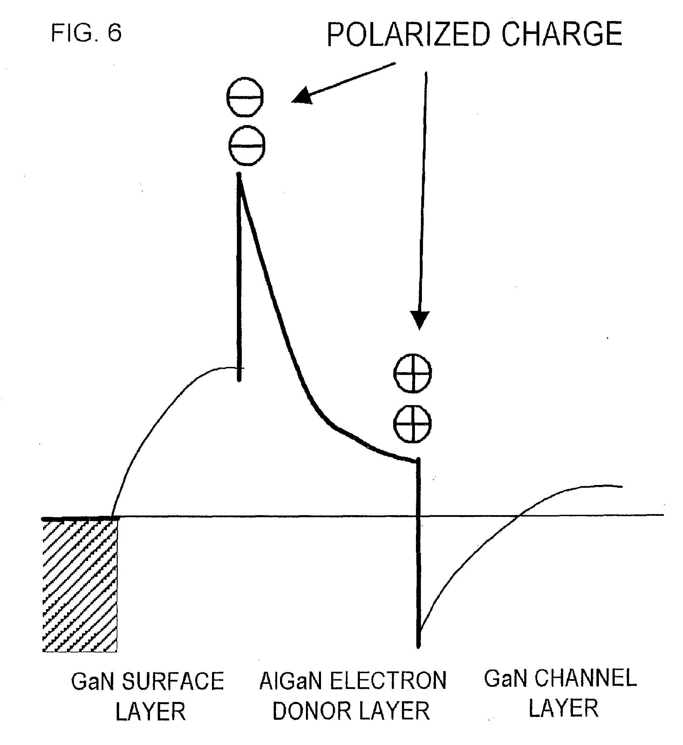

In the configuration shown in FIG. 5, the GaN layer 37 provided as the surface layer has an effect of improving the problems of deep levels ascribable to the AlGaN electron donor layer 36 and of oxidation. Stable operation may therefore be obtained. This topic will be explained referring to FIG. 6. FIG. 6 is a drawing showing a band chart right under the gate electrode 32 of the transistor shown in FIG. 5. The "GaN surface layer" in FIG. 6 corresponds to the GaN layer 37.

As shown in FIG. 6, by introducing the surficial GaN layer 37, an effective Schottky barrier height of the AlGaN electron donor layer 36 at the interface between the GaN layer 37 and the AlGaN electron donor layer 36 may be increased. As a consequence, the breakdown voltage of gate may be improved.

In addition, by introducing the surficial GaN layer 37, negative polarized charge which resides in the AlGaN electron donor layer 36 at the interface of the surficial AlGaN electron donor layer 36, that is, at the interface of the GaN layer 37 and the AlGaN electron donor layer 36, may be brought away from the surface of the AlGaN electron donor layer 36. Therefore, influence of formation of the SiN film 38 may distinctively be reduced. As a consequence, the collapse may be reduced, and operations may be stabilized.

However, from our investigations, the present inventors found out new problems which have never been known before, when the conventional configuration shown in FIG. 5 was adopted.

First, the configuration shown in FIG. 5 is increased in the sheet carrier concentration, by doping the GaN layer 37 so as to lower an effective barrier height to thereby lower the interfacial potential. More specifically, Patent Document 2 mentioned in the section of BACKGROUND ART describes formation of an n-type GaN protective layer having a dopant concentration of $2\times10^{18}$ cm$^{-3}$.

It was, however, anticipated from the investigations by the present inventors that raised dopant concentration of the GaN layer 37 might increase concentration of electric field at the drain-side end of the gate electrode 32. Moreover, electric field intensity in the ungate region between the gate and the drain may increase, and thereby the breakdown voltage of gate may degrade.

On the other hand, for the case where the surficial GaN layer 37 remains undoped (i-GaN) in the configuration shown in FIG. 5, the sheet carrier (two-dimensional electron gas) concentration in the channel right under the gate electrode 32 may lower, and therefore the channel current may be produced only to an insufficient degree.

In the transistor shown in FIG. 5, the gate electrode 32 as a Schottky electrode is formed on the surficial GaN layer 37. In this case, the depletion layer in the region right under the gate electrode 32 resides at the same position with the surface depletion layer ascribable to deep levels which resides in the surficial portion of the GaN layer 37. This means that the depletion layer right under the gate electrode 32 cannot fully be exempt from influences of the depletion layer in the ungate region. As a consequence, releasing and trapping of carrier by the surficial levels generated in the vicinity of the surface of the GaN layer 36 in the ungate region may occasionally not fully responsive to high frequency of large signal input to the gate electrode 32, in particular in the vicinity of the gate end on the drain side. It was also anticipated that the above-described surficial levels may raise a reason for another current collapse, and may prevent a sufficient level of high-frequency output from being extracted. It has therefore been anticipated that the power density could not fully be increased.

The present invention was conceived after considering the above-described situation, and is to provide a transistor excellently balanced between collapse and breakdown voltage of gate.

Based the above-described topics, the present inventors went into further investigations. The present inventors finally found out a structure described below, capable of suppressing the collapse ascribable to the surficial levels, while reducing influences of deep levels in the AlGaN layer and thereby keeping a high breakdown voltage of gate, and reached the present invention.

According to the present invention, there is provided a field effect transistor which includes a channel layer composed of a first undoped GaN layer; an electron donor layer provided on the channel layer as being brought into contact therewith, and is composed of $Al_xGa_{1-x}N$ ($0<x\leq1$); a second undoped GaN layer provided on the electron donor layer; a source electrode and a drain electrode provided as being spaced from each other on the second undoped GaN layer; a recess provided in the region between the source electrode and the drain electrode, as being extended through the second undoped GaN layer; a gate electrode buried in the recess as being brought into contact with the side wall of the recess specifically on the drain electrode side thereof, and as being brought into contact at the bottom thereof with the electron donor layer; and an insulating film provided on the second undoped GaN layer, in the region between the gate electrode and the drain electrode.

In the field effect transistor of the present invention, the gate electrode is brought into contact at the bottom thereof with the electron donor layer, and the second undoped GaN layer is provided on the electron donor layer in the region between the gate electrode and the drain electrode. Negative polarized charge which resides in the electron donor layer may, therefore, be brought apart from the surface of the electron donor layer. Accordingly, the collapse may effectively be suppressed.

The gate electrode is buried in the recess as being brought into contact with the side wall of the recess on the drain electrode side. In other words, the second undoped GaN layer is provided as being extended from the side face of the gate electrode to the drain electrode, in the region between the gate electrode and the drain electrode. Because the electron donor layer is completely covered with the second undoped GaN layer, in the region thereof at the end portion of the gate electrode on the drain electrode side, the surface potential of the ungate region and the surface potential right under the gate electrode may completely be isolated. By virtue of this configuration, the region incapable of responding high frequency and affective to high-frequency characteristics of the region right under the gate electrode will never be formed in the ungate region in the vicinity of the end portion of the gate electrode on the drain electrode side thereof. According to this configuration, the collapse may completely be avoidable. Consequently, this configuration may successfully improve the high-frequency characteristics, and may improve the operational stability.

The present invention is also successful in moderating concentration of electric field at the drain-side end of the gate electrode, and in improving the breakdown voltage of gate, because the undoped GaN layer is provided between the electron donor layer and the insulating film.

Because the gate electrode is buried in the recess in the present invention, the second undoped GaN layer is consequently disposed in the vicinity of the side face of the gate electrode on the drain side thereof. This configuration is, therefore, capable of more effectively suppressing concentration of electric field at the drain-side end of the gate electrode.

Because the undoped GaN layer is provided over the electron donor layer between the gate electrode and the drain electrode in the present invention, electric field intensity in the ungate region between the gate and the drain may be lowered. Breakdown voltage of gate may, therefore, be improved.

In the present invention, the recess is provided as being extended through the second undoped GaN layer. The recess may typically be formed by recess etching. The gate electrode is formed as being buried in the recess, and brought into contact at the bottom thereof with the electron donor layer. By virtue of this configuration, sheet carrier concentration in the channel right under the gate electrode may be ensured at a sufficient level, even for the case where the undoped GaN layer is provided over the electron donor layer. Therefore, channel current may be produced to a sufficient degree.

As is clear from the above, the field effect transistor of the present invention may improve trade-off between the collapse and the breakdown voltage of gate, wherein the breakdown voltage of gate may be improved, and the collapse may be suppressed at the same time.

In the field effect transistor of the present invention, in the sectional view taken along the direction of gate length, the side wall of the recess and the side wall of the gate electrode both on the source electrode side and on the drain electrode side thereof may be brought into direct contact with each other. This configuration may further improve the source resistivity, and may improve the device characteristics.

In the field effect transistor of the present invention, the gate electrode may completely fill up the recess.

In the field effect transistor of the present invention, the gate electrode may have a field plate portion formed on the insulating film as being swelled out thereon towards the drain electrode side like a penthouse. By virtue of this configuration, concentration of electric field at the drain-side end of the gate electrode may more effectively be moderated. Therefore, the breakdown voltage of gate may further be improved.

In the present invention, an insulating film having a low interfacial level density may be adoptable as the insulating film provided over the second undoped GaN layer in the region other than the vicinity of the gate electrode.

By virtue of this configuration, the collapse possibly occurs between the gate electrode and the drain electrode may further effectively be suppressed. This sort of insulating film may specifically be exemplified by nitrogen-containing insulating film, and further specifically by SiN film, SiON film and SiCN film. In this way, the transistor reduced in the collapse and gate leakage current, and further suitable for higher output configuration, may be obtained.

In the present invention, the gate electrode may have a T-form, or Y-form. By virtue of this configuration, the gate resistivity may be reduced, the gain may be increased, and thereby the high-frequency characteristics may further be improved.

As is clear from the explanation in the above, the present invention may realize a transistor excellently balanced between the collapse and the breakdown voltage of gate.

BRIEF DESCRIPTION OF THE DRAWINGS

The above and other objects, advantages and features of the present invention will be more apparent from the following description of certain preferred embodiments taken in conjunction with the accompanying drawings.

FIG. 1 is a sectional view showing a configuration of a semiconductor device in an embodiment;
FIG. 2 is a sectional view showing a configuration of a conventional semiconductor device;
FIG. 3 is a drawing showing a band chart of the region right under the gate electrode of the semiconductor device shown in FIG. 2;
FIG. 4 is a drawing showing results of measurement of IV characteristics of the semiconductor device;
FIG. 5 is a sectional view showing a configuration of a conventional semiconductor device;
FIG. 6 is a drawing showing a band chart of the region right under the gate electrode of the semiconductor device shown in FIG. 5;
FIG. 7 is a drawing showing a band chart of the region right under the gate electrode and the ungate region of the semiconductor device of the embodiment;
FIG. 8 is a drawing showing relations between thickness of the undoped GaN layer and effective barrier height of the semiconductor device of the embodiment; and
FIG. 9 is a drawing showing relations between thickness of the undoped GaN layer and sheet carrier density of the semiconductor device of the embodiment.

BEST MODE FOR CARRYING OUT THE INVENTION

Embodiments of the present invention will be explained below, referring to the attached drawings. It is to be noted that any common constituents will be given with same reference numerals in all drawings, so that the explanations therefor will not be repeated for the convenience' sake. In this specification, all stacked structures will be expressed as "upper layer/lower layer (substrate side)".

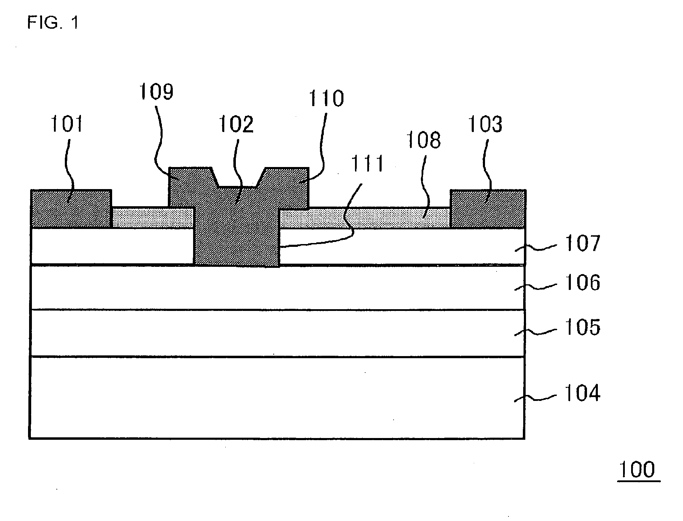

FIG. 1 is a sectional view showing a configuration of a compound semiconductor device. A semiconductor device 100 is a hetero-junction field effect transistor using a nitride-base Group III-V compound semiconductor for the channel layer.

The semiconductor device 100 has a Group III nitride semiconductor structure composed of an undoped GaN (i-GaN) channel layer 105, an AlGaN electron donor layer 106 provided over the undoped GaN channel layer 105 as being brought into contact therewith, and an undoped GaN (i-GaN) layer 107 provided over the AlGaN electron donor layer 106 as being brought into contact therewith.

In the semiconductor device 100, the channel, or the two-dimensional electron gas, is induced by polarized charge and a donor layer of the AlGaN electron donor layer 106.

The undoped GaN channel layer 105 is provided as being brought into contact with a substrate 104, and is a first undoped GaN layer which functions as an electron moving layer. The undoped GaN channel layer 105 functions as a channel layer. The substrate 104 is typically composed of a high-resistivity SiC substrate.

The AlGaN electron donor layer 106 is provided over the undoped GaN channel layer 105 as being brought into contact therewith, and composed of $Al_xGa_{1-x}N$ ($0<x\leq1$). The AlGaN electron donor layer 106 functions as an electron donor layer. The AlGaN electron donor layer 106 is typically composed of a doped n-AlGaN layer.

The undoped GaN layer 107 is a second undoped GaN layer provided over the AlGaN electron donor layer 106. The undoped GaN (i-GaN) layer 107 functions as a surface layer. The surface of the undoped GaN layer 107 is provided with surface protection using a SiN film 109 which is a nitrogen-containing insulating film.

On predetermined regions on the undoped GaN layer 107, a source electrode 101 and a drain electrode 103 are provided as being spaced from each other.

In the region between the source electrode 101 and the drain electrode 103, a recess 111 extended through the undoped GaN layer 107 is provided. The bottom surface of the recess 111 is composed of the AlGaN electron donor layer 106. The side face of the recess 111 is composed of the inner walls of an opening extending through the undoped GaN layer 107 and the SiN film 108. This sort of recess 111 may be formed by recess etching.

In the region between the source electrode 101 and the drain electrode 103, a gate electrode 102 is provided on the top surface of the AlGaN electron donor layer 106 as being brought into contact therewith. The gate electrode 102 is buried in the recess 111, and brought into Schottky contact at the bottom thereof with the AlGaN electron donor layer 106.

In the semiconductor device 100, the gate electrode 102 completely fills up the recess 111, wherein the side wall of the recess 111 and the side wall of the gate electrode 102 on the drain electrode 103 side thereof are brought into direct contact with each other, in the sectional view taken along the direction of gate length. In the semiconductor device 100, the side wall of the recess 111 and the side wall of the gate electrode 102 on the source electrode 101 side are brought into direct contact with each other.

FIG. 1 herein showed an exemplary configuration in which the bottom level of the gate electrode 102 and the top level of the AlGaN electron donor layer 106 agreed, but the configuration is not limited thereto so far as concentration of electric field at the drain-side end of the gate electrode 102 may sufficiently be suppressed, allowing for example that the portion at around the bottom of the gate electrode 102 may depress into the AlGaN electron donor layer 106.

An interposer layer may be provided between the gate electrode 102 and the AlGaN electron donor layer 106, in the region right under the gate electrode 102, so far as the sheet carrier concentration right under the gate electrode 102 may be ensured at a sufficient level.

The interposer layer may be provided also between the AlGaN electron donor layer 106 and the undoped GaN layer 107, so far as the surface potential in the region right under the gate electrode 102 and the surface potential in the ungate region may reliably be isolated.

The gate electrode 102 has a field plate portion (swelled portion 110) formed on the SiN film 108 as being swelled out thereon towards the drain electrode 103 side like a penthouse. In the semiconductor device 100, the swelled portion 109 which functions as the field plate is provided also to the gate electrode 102 on the source electrode 101 side thereof.

The insulating film (SiN film 108) is provided in the region between the gate electrode 102 and the drain electrode 103, as being brought into contact with the undoped GaN layer 107. The SiN film 108 functions as a surface protective film (simply referred to as "protective film", hereinafter).

Next, a method of manufacturing the semiconductor device 100 will be explained.

First, on the substrate 104 composed of high-resistivity SiC, the undoped GaN channel layer 105 which functions as a channel layer, the AlGaN electron donor layer 106, and the undoped GaN layer 107 which functions as a surface layer are sequentially stacked. Then the SiN film 108 is deposited by CVD on the undoped GaN layer 107. The SiN film 108 is selectively etched off in the regions where the gate electrode 102, the drain electrode 103 and the source electrode 101 will be formed later, to thereby form openings.

Then the individual electrodes are formed in the openings. In this process, the source electrode 101 and the drain electrode 103 are formed, and ohmic contact is established typically by annealing at 650°C. The gate electrode 102 is formed in such a way that the undoped GaN layer 107 exposed in the opening of the SiN film 108 is etched off in the region destined for formation thereof, metals such as Ni (upper layer)/Au (lower layer (substrate side)) is deposited by vacuum evaporation, and the gate electrode 102 is formed over the AlGaN electron donor layer 106. Etching of the undoped GaN layer 107 is preferably proceeded by dry etching. By adopting dry etching, the side wall of the gate electrode 102 and the side wall of the undoped GaN layer 107 may be formed while preventing any gap from being formed in between, so that the configuration in which they are brought into direct contact on their side faces may be obtained in a stable manner with high yield. According to the above-described procedures, the semiconductor device 100 shown in FIG. 1 may be obtained.

In thus-obtained semiconductor device 100, the recess 111 is formed as being extended through the SiN film 108 and the undoped GaN layer 107, in the predetermined region between the source electrode 101 and the drain electrode 103. The gate electrode 102 completely fills up the recess 111, brought into contact with the AlGaN electron donor layer 106 at the bottom thereof, and brought into contact with the undoped GaN layer 107 on the side face thereof.

Now referring back to FIG. 2, the conventional semiconductor device explained in the above had the SiN film 27 formed on the AlGaN electron donor layer 26 as being brought into direct contact therewith, in the region between the gate electrode 22 and the drain electrode 23. The configuration has, however, been suffering from lowering in the breakdown voltage of gate when the thickness of the SiN film 27 is increased aiming at suppressing the collapse, due to concentration of electric field at the drain-side end of the gate electrode 22.

In contrast, in the semiconductor device 100 shown in FIG. 1, the undoped GaN layer 107 is interposed between the AlGaN electron donor layer 106 and the SiN film 108, in the region between the gate electrode 102 and the drain electrode 103. Therefore, concentration of electric field at the drain-side end of the gate electrode 102 may be suppressed even when the thickness of the SiN film 108 is increased, and thereby breakdown voltage of gate may be improved. This effect becomes distinctive when the bottom position of the gate electrode 102, and the position of interface between the AlGaN electron donor layer 106 and the undoped GaN layer 107 agree as shown in FIG. 1. This effect becomes distinctive also when the undoped GaN layer 107 is formed as being brought into contact with the side face of the gate electrode 102 on the drain side thereof, as shown in FIG. 1. This effect becomes distinctive still also when the undoped GaN layer 107 is formed in the region between the drain-side end of the gate electrode 102 and the gate-side end of the drain electrode 103, that is, over the entire range of the ungate region.

One known technique of interposing the GaN layer between the electron donor layer and the SiN film has been described above in the BACKGROUND ART referring to FIG. 5. The device shown in FIG. 5 has improved the sheet carrier concentration, by doping the GaN layer 37 on the AlGaN electron donor layer 36 to thereby lower the effective barrier height. This technique has, however, been anticipated in that increase in the doping concentration of the GaN layer 37 might enhance concentration of electric field at the drain-side end of the gate electrode 32, or may enhance electric field intensity in the ungate region, and thereby the breakdown voltage of gate might be degraded.

In contrast, in the semiconductor device 100, the undoped GaN layer 107 is provided as an interposer layer between the AlGaN electron donor layer 106 and the SiN film 108. Accordingly, breakdown voltage of gate may be prevented from degrading while ensuring a sufficient level of effective barrier height in the ungate region. More specifically, concentration of electric field at the drain-side end of the gate electrode 102 may be suppressed, and electric field intensity in the ungate region may effectively be lowered.

In addition, in the semiconductor device 100, the gate electrode 102 is buried in the undoped GaN layer 107, and the bottom surface of the gate electrode 102 and the AlGaN electron donor layer 106 come into contact with each other. By virtue of this configuration, the sheet carrier concentration in the region right under the gate electrode 102 may be increased to a sufficient degree, despite the configuration having the undoped GaN layer 107 provided on the AlGaN electron donor layer 106.

As has been described in the above, the semiconductor device 100 may achieve both of increase in the channel current and improvement in the breakdown voltage of gate. More specifically, the configuration achieved herein is excellent in the IV characteristics by virtue of provision of the SiN film 108 on the undoped GaN layer 107, and may suppress the hystereses in the IV curves, having been explained in the above referring to FIG. 4.

In the semiconductor device 100, the effect of moderating concentration of electric field at the drain-side end of the gate electrode 102 may be expressed irrespective of sectional geometry of the gate electrode 102 as viewed in the direction of gate length. Accordingly, the breakdown voltage of gate may effectively be improved not only for the case where the swelled portion 110, which functions as a field plate portion, is provided to the gate electrode 102 as shown in FIG. 1, but also for the case where, for example, the sectional geometry of the gate electrode 102 is rectangular as shown in FIG. 2 and FIG. 5.

In the configuration shown in FIG. 1, the gate electrode 102 has the swelled portion 109 and the swelled portion 110 to give the field plate structure. Concentration of electric field typically at the end portion of the gate electrode 102 on the drain electrode side may be moderated in a more effective manner. As a consequence, the reverse breakdown voltage of gate may further be improved.

In the semiconductor device 100, the gate electrode 102 is buried in the recess 111, and the side wall of the gate electrode 102 is brought into direct contact with the side wall of the recess 111, on both of the source electrode 101 side and the drain electrode 103 side of the gate electrode 102. Because the undoped GaN layer 107 and the gate electrode 102 are brought into contact not only on the drain electrode 103 side but also on the source electrode 101 side, the semiconductor device 100 is configured as being effectively reduced in the source resistivity. Therefore, according to the semiconductor device 100, device characteristics, including current gain characteristic and high-speed performance, may be improved.

In the semiconductor device 100, the undoped GaN layer 107 is provided on the AlGaN electron donor layer 106 between the gate electrode 102 and the drain electrode 103. By virtue of this configuration, in the ungate region, the surface potential in the region where the undoped GaN layer 107 is provided and the surface potential in the region right under the gate electrode 102 may be isolated. What is better, the gate electrode 102 is buried in the recess 111, and the undoped GaN layer 107 extends towards the drain-side end of the gate electrode 102, so as to prevent the depletion layer of the ungate region from affecting the depletion layer in the region right under the gate electrode 102. Therefore, any new collapse will be prevented from occurring. This effect may distinctively be expressed by the configuration in which the recess 111 is completely filled up with the gate electrode 102 as shown in FIG. 1, wherein such configuration may suppress the collapse in a substantially complete manner.

In short, in the semiconductor device 100, the recess 111 is completely filled up with the gate electrode 102, and the undoped GaN layer 107 is formed as being extended from the region right under the drain electrode 103 to the side face of the gate electrode 102. The gate electrode 102 is brought into contact, on the side face thereof, with the undoped GaN layer 107. The gate electrode 102 is brought into contact, on a part of the side face thereof, also with the SiN film 108 provided on the top of the undoped GaN layer 107. As a consequence, the semiconductor device 100 is configured so that the surface potential in the region right under the gate electrode 102 and the surface potential of the region between the gate electrode 102 and the drain electrode 103, or the ungate region, may completely be isolated.

Therefore, the semiconductor device 100 is configured so that the surface potential in the region right under the gate electrode 102 and the surface potential in the ungate region may be designed in an arbitrary and independent manner, intentionally making them different from each other.

In the semiconductor device described in the above referring to FIG. 2 and FIG. 5, the gate electrode 102 and the drain electrode 103 are provided on the same layer, so that the surface potential in the ungate region and the surface potential in the region right under the gate electrode could not be isolated. For this reason, the depletion layer in the ungate region might adversely affect the depletion layer in the region right under the gate electrode, and thereby the high-frequency characteristics might be degraded.

In contrast, in the semiconductor device 100, the side face of the gate electrode 102 is brought into direct contact with the undoped GaN layer 107, so that the surface potential in the region right under the gate electrode 102 and the surface potential in the ungate region are completely isolated. Because the depletion layer right under the gate electrode 102 is completely isolated form the surface levels of the undoped GaN layer 107, the region incapable of responding high frequency and affective to high-frequency characteristics of the region right under the gate electrode 102 will never be formed in the ungate region in the vicinity of the drain-end side of the gate electrode 102.

Therefore, according to the semiconductor device 100, influence of the collapse ascribable to the surface levels in the ungate region may completely be excluded. As a consequence, trapping and release of carriers will not adversely affect high-frequency under large signal input to the gate electrode 102, and thereby a sufficient level of high-frequency output may be extracted.

Influences expectable from the case where the gate electrode 102 is completely buried in the undoped GaN layer 107 will more specifically be explained.

In the semiconductor device 100, polarized charge generates in the AlGaN electron donor layer 106, and the potential is raised particularly on the surficial side thereof.

If the undoped GaN layer 107 is introduced to the surface of the AlGaN electron donor layer 106, and the gate electrode 102 is completely buried in the undoped GaN layer 107, the portion having the gate electrode 102 formed therein (gate region) and the ungate region will be varied in the band structure.

Effective Schottky barrier heights of the gate region and the ungate region, produced as a result of burying of the gate, are now assumed as $e\varphi b$ (AlGaN) and $e\varphi b$ (eff), respectively. They are determined by amount of doping ($N_d$) of the AlGaN electron donor layer 106, thickness ($t_{AlGaN}$) of the AlGaN electron donor layer 106, thickness ($t_{GaN}$) of the undoped GaN layer 107, sheet carrier concentration ($n_s$) and $\Delta Ec$ (barrier height).

Relations of magnitude of $e\varphi b$(AlGaN) and $e\varphi b$ (eff) may be expressed as the equations (1) to (3), classified by cases.

$$N_d{}^* t_{AlGaN} > n_s + t_{GaN}{}^* (\partial n_s / \partial t_{GaN}), \quad n_s = n_s(t_{AlGaN}, \; t_{GaN}, \; N_d) \quad (1)$$

The equation (1) indicates that the Schottky barrier height right under the gate electrode 102 becomes smaller than that of the ungate region, and that the sheet carrier concentration of the ungate region is larger than that of the gate region.

$$N_d{}^* t_{AlGaN} = n_s + t_{GaN}{}^* (\partial n_s / \partial t_{GaN}), \quad n_s = n_s(t_{AlGaN}, \; t_{GaN}, \; N_d) \quad (2)$$

The equation (2) indicates that the Schottky barrier height right under the gate electrode 102 and the barrier height of the ungate region become equal, and that the situation becomes equivalent to that the the undoped GaN layer does not electrically exist in the surface layer.

$$N_d{}^* t_{AlGaN} < n_s + t_{GaN}{}^* (\partial n_s / \partial t_{GaN}), \quad n_s = n_s(t_{AlGaN}, \; t_{GaN}, \; N_d) \quad (3)$$

The equation (3) indicates that the Schottky barrier height right under the gate electrode 102 becomes larger than the barrier height of the ungate region, and that the sheet carrier concentration of the ungate region is smaller than that of the gate region.

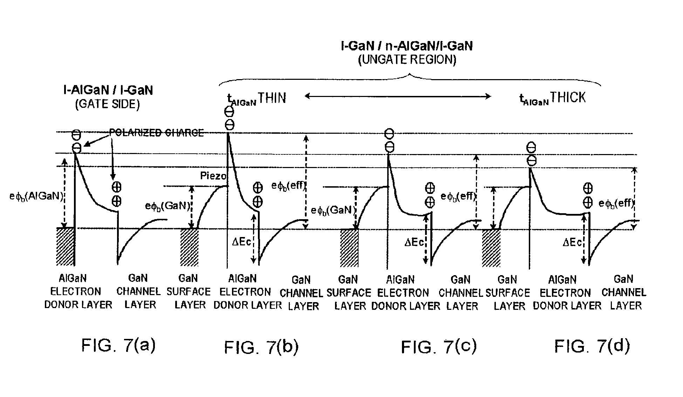

The relations expressed by the equations (1) to (3) will be explained referring to FIG. 7 (a) to FIG. 7(d). FIG. 7(a) to FIG. 7(d) are drawings showing band charts of the region right under the gate electrode 102 and the ungate region of the semiconductor device 100.

FIG. 7(a) is a band chart of the region right under the gate electrode 102. As described previously referring to FIG. 1, in the region right under the gate electrode 102, the band chart is given as shown herein, because the undoped GaN layer 107 is removed by recess etching.

FIG. 7(b) to FIG. 7(d) show the ungate region having the undoped GaN layer 107 formed thereon, wherein thickness of the AlGaN electron donor layer 106 was varied in three ways.

For the case where the thickness of the AlGaN electron donor layer 106 is small (FIG. 7(b)), the potential is raised by the undoped GaN layer 107. As a consequence, the effective barrier height becomes larger than that in the region right under the gate electrode 102. The situation corresponds to the relation expressed by the equation (1).

Conversely, for the case where the thickness of the AlGaN electron donor layer 106 is large (FIG. 7(d)), the effective barrier height of the ungate region is suggested to fall below that of the gate region. The situation corresponds to the relation expressed by the equation (3).

Still alternatively, there may be a condition under which the effective barrier height of the gate region and the ungate region will become equal, depending on the thickness of the AlGaN electron donor layer 106 (FIG. 7 (c)). The situation corresponds to the relation expressed by the equation (2).

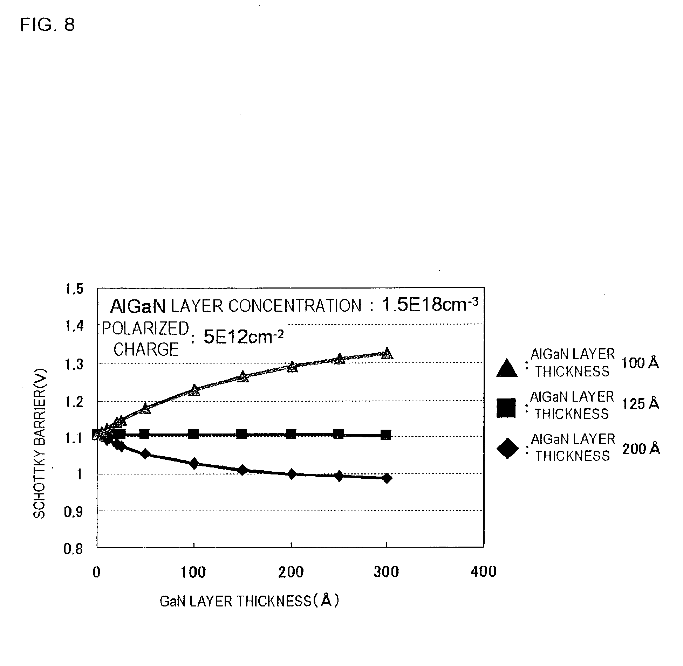

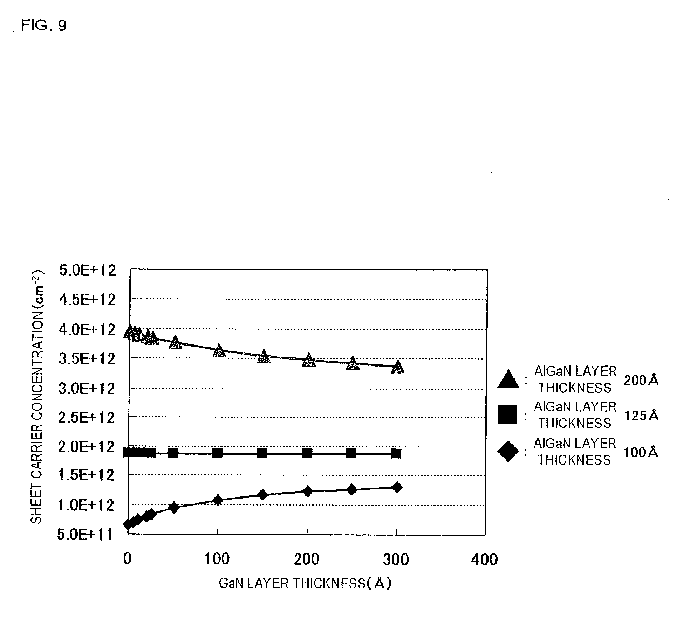

FIG. 8 and FIG. 9 are drawings showing potential distribution in the gate region and the ungate region calculated using the equations (1) to (3). In FIG. 8 and FIG. 9, a thickness of the undoped GaN layer 107, plotted on the abscissa, of zero corresponds to the gate region, and the positive zone of the thickness of the undoped GaN layer 107 corresponds to the ungate region.

First, FIG. 8 is a drawing showing relations between the thickness of the undoped GaN layer 107 and the effective Schottky barrier height $e\varphi b$ (eff). FIG. 8 shows results of band calculation obtained when the carrier concentration of the AlGaN electron donor layer 106 was assumed as $1.5\times10^{18}$ cm$^{-3}$, and the polarized charge density was assumed as $5\times10^{12}$ cm$^{-2}$.

It is known from FIG. 8 that, when the thickness of the AlGaN electron donor layer 106 is 100 Å (10 nm), $e\varphi b$ (eff) in the ungate region increases as the thickness of the undoped GaN layer 107 increases. On the other hand, when the thickness of the AlGaN electron donor layer 106 is 200 Å, $e\varphi b$(eff) conversely decreases as the thickness of the undoped GaN layer 107 increases.

Still alternatively, when the thickness of the AlGaN electron donor layer 106 is 125 Å, $e\varphi b$ (eff) is kept constant irrespective of the thickness of the undoped GaN layer 107, and becomes equal to the case where the thickness of the undoped GaN layer 107 is zero. The structure attained in this case is such as having $e\varphi b$ (eff) of the ungate region equals to $e\varphi b$ (AlGaN) of the gate region.

As shown in FIG. 8, in the semiconductor device 100, the surface characteristics of the gate region and the ungate region may be designed by adjusting the thickness of the AlGaN electron donor layer 106.

In particular, as shown in the equation (1) and FIG. 7(b), for the case where the potential of the ungate region is larger than the potential right under the gate, electrons moving from the gate electrode 102 to the drain electrode 103 cannot pass through the ungate region without jumping over the difference in potential barrier height. Therefore, leakage current, otherwise occurs when reverse voltage is applied between the gate and the drain may distinctively be reduced. This means that a very high breakdown voltage of gate may be obtainable.

In view of producing a sufficient level of channel current in the semiconductor device 100, the sheet carrier concentration may preferably be set large. In addition, in view of reducing the resistivity in the region right under the drain electrode, the thickness of the undoped GaN layer 107 may preferably be set, for example, to 200 Å or smaller, and more preferably to 100 Å or smaller.

The present inventors then made further investigation aiming at realizing a configuration having high sheet carrier concentration while suppressing the thickness of the undoped GaN layer 107 to a small level. Results of calculation are shown in FIG. 9. FIG. 9 is a drawing showing the sheet carrier concentration varied depending on the thickness of the undoped GaN layer 107, obtained under the same conditions with those shown in FIG. 8. Also in FIG. 9, calculation was made for each of the cases where the thickness of the AlGaN electron donor layer 106 was adjusted to 100 Å, 125 Å and 200 Å, similarly to as shown in FIG. 8.

As is known from FIG. 9, the sheet carrier concentration becomes 1E12/cm$^2$ or around when the thickness of the undoped GaN layer 107 is 100 Å or smaller. No distinctive increase or decrease is found depending on changes in concentration of the AlGaN electron donor layer 106.

On the other hand, when the thickness of the undoped GaN layer 107 is 125 Å and 200 Å, the sheet carrier concentration may further be increased even if the thickness of the AlGaN electron donor layer 106 falls in a relatively small range of approximately 100 Å or smaller. It is, therefore, made clear that, if the thickness of the undoped GaN layer 107 is set to 125 Å and 200 Å, still better potential design under a high degree of freedom may be allowable both for the gate electrode portion and the ungate region, without taking changes in the sheet carrier concentration into consideration.

Results shown in FIG. 8 and FIG. 9 express characteristics obtainable by burying the gate electrode 102 into the undoped GaN layer 107.

As has been described in the above, the semiconductor device 100, which is a hetero-junction field effect transistor using a nitride-base Group III-V compound semiconductor for the channel layer, is configured as being well balanced between the collapse and high breakdown voltage of gate, and may be operated under high frequency, and may stably be operated under high current density. The semiconductor device 100 is also configured as being excellent in reliability and operational stability.

The embodiments of the present invention have been described in the above, referring to the attached drawings, merely as examples of the present invention, allowing adoption of various configurations other than those described in the above.

For example, the explanation in the above dealt with the exemplary case where the AlGaN layer on the undoped GaN channel layer 105 was composed of the AlGaN electron donor layer 106 configured by a doped n-AlGaN. layer, wherein the AlGaN electron donor layer 106 on the undoped GaN channel layer 105 may be undoped (i-AlGaN) or doped (n-AlGaN). Alternatively, the AlGaN electron donor layer 106 may be configured as having i-AlGaN and n-AlGaN stacked in this order.

The explanation in the above dealt with the exemplary case where the SiN film 108 was provided on the undoped GaN layer 107, wherein the insulating film on the undoped GaN layer 107 is not limited to the SiN film 108 so far as it may function as a surface protective film suppressive to current collapse. For example, any film containing nitrogen as a constitutive element, such as SiON film or SiCN film, may be adoptable in place of the SiN film 108.

The explanation in the above dealt with the case where the high-resistivity SiC was used as a material composing the substrate 104, wherein a low-resistivity substrate may also be adoptable. Alternatively, any other different species of substrate materials, such as sapphire, or Group III nitride semiconductor substrate such as made of GaN, AlGaN and so forth may be adoptable.

## Claims

1.  A field effect transistor comprising:

    a channel layer composed of a first undoped GaN layer;
    an electron donor layer provided on said channel layer as being brought into contact therewith, and is composed of $Al_xGa_{1-x}N$ ($0<x\leq1$) ;
    a second undoped GaN layer provided on said electron donor layer;
    a source electrode and a drain electrode provided as being spaced from each other on said second undoped GaN layer;
    a recess provided in the region between said source electrode and said drain electrode, as being extended through said second undoped GaN layer;
    a gate electrode buried in said recess as being brought into contact with the side wall of said recess specifically on said drain electrode side thereof, and as being brought into contact at the bottom thereof with said electron donor layer; and
    an insulating film provided on said second undoped GaN layer, in the region between said gate electrode and said drain electrode.

2.  The field effect transistor as claimed in Claim 1,
    wherein, in a sectional view taken along the direction of gate length,
    the side wall of said recess and the side wall of said gate electrode both on said source electrode side and on said drain electrode side thereof are brought into direct contact with each other.

3.  The field effect transistor as claimed in Claim 1 or 2,
    wherein said recess is formed by recess etching.

4.  The field effect transistor as claimed in any one of Claims 1 to 3,
    wherein said gate electrode has a field plate portion formed on said insulating film as being swelled out thereon towards said drain electrode side like a penthouse.

5.  The field effect transistor as claimed in any one of Claims 1 to 4,
    wherein said insulating film is any one of SiN film, SiON film and SiCN film.

FIG. 1

100

EP 1 962 338 A1

FIG. 2

21    22    27    23

26

25

24

12

FIG. 3

POLARIZED CHARGE

AlGaN ELECTRON DONOR LAYER

GaN CHANNEL LAYER

FIG. 4

FIG. 5

FIG. 6

POLARIZED CHARGE

GaN SURFACE
LAYER

AlGaN ELECTRON
DONOR LAYER

GaN CHANNEL
LAYER

FIG. 7(a)   FIG. 7(b)   FIG. 7(c)   FIG. 7(d)

FIG. 8

AlGaN LAYER CONCENTRATION : 1.5E18cm⁻³

POLARIZED CHARGE : 5E12cm⁻²

▲ : AlGaN LAYER THICKNESS 100 Å

■ : AlGaN LAYER THICKNESS 125 Å

◆ : AlGaN LAYER THICKNESS 200 Å

SCHOTTKY BARRIER(V)

GaN LAYER THICKNESS(Å)

FIG. 9

**INTERNATIONAL SEARCH REPORT**

| International application No. |
|---|
| PCT/JP2006/324753 |

A. CLASSIFICATION OF SUBJECT MATTER
*H01L21/338*(2006.01)i, *H01L29/06*(2006.01)i, *H01L29/778*(2006.01)i,
*H01L29/812*(2006.01)i

According to International Patent Classification (IPC) or to both national classification and IPC

B. FIELDS SEARCHED

Minimum documentation searched (classification system followed by classification symbols)
H01L21/338, H01L29/06, H01L29/778, H01L29/812

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho  1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-129856 A  (The Furukawa Electric Co., Ltd.), 19 May, 2005 (19.05.05), Fig. 1 (Family: none) | 1-5 |
| A | JP 2002-289837 A  (Matsushita Electric Industrial Co., Ltd.), 04 October, 2002 (04.10.02), Fig. 1 & EP 1246256 A2         & US 2002/0139995 A1 | 1-5 |
| A | JP 2005-210105 A  (Matsushita Electric Industrial Co., Ltd.), 04 August, 2005 (04.08.05), Fig. 11 & US 2005/0139838 A1 | 1-5 |

| ☒ | Further documents are listed in the continuation of Box C. | ☐ | See patent family annex. |

\* Special categories of cited documents:
"A" document defining the general state of the art which is not considered   to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 05 March, 2007 (05.03.07) | Date of mailing of the international search report 13 March, 2007 (13.03.07) |
|---|---|
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/324753

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-277357 A  (NGK Insulators, Ltd.),<br>06 October, 2005 (06.10.05),<br>Fig. 8<br>(Family: none) | 1-5 |
| E,A | JP 2007-035905 A  (Toshiba Corp.),<br>08 February, 2007 (08.02.07),<br>Fig. 6<br>(Family: none) | 1-5 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004342810 A
- JP 2002359256 A